# EUROPEAN PATENT SPECIFICATION

(11) **EP 3 478 737 B1**
(45) Date of publication and mention of the grant of the patent: **15.07.2020**
(21) Application number: 17740100.7
(22) Date of filing: 12.06.2017
(51) Int. Cl.: C08F 220/24, C09D 133/16, H03K 17/96, G06F 3/041

(54) **A PERFLUORINATED COPOLYMER FOR TRIBOELECTRIC SENSORS**
EIN PERFLUORIERTER POLYMER FÜR TRIBOELEKTRISCHE SENSOREN
COPOLYMÈRE PERFLUORÉ POUR CAPTEURS TRIBOÉLECTRIQUES

(30) Priority: 30.06.2016 US 201662356694 P
(43) Date of publication of application: 08.05.2019
(73) Proprietor: SABIC Global Technologies B.V., 4612 PX Bergen op Zoom (NL)
(72) Inventor: FRESCAS, Jesus Alfonso Caraveo, Thuwal 23955-6900 (SA); ALDUBAYAN, Abdulaziz Hamad M., Thuwal 23955-6900 (SA); FARAH, Abdiaziz A., Thuwal 23955-6900 (SA)
(74) Representative: J A Kemp LLP
(86) International application number: PCT/IB2017/053473
(87) International publication number: WO 2018/002753

(56) References cited:
- US-A1- 2016 070 392
- US-A1- 2016 149 518

## Description

### FIELD OF THE DISCLOSURE

The instant disclosure relates to user input devices. More specifically, this disclosure relates to user input devices based on triboelectric sensors.

### BACKGROUND

Electronic devices, particularly consumer electronics, must interact with users of the devices by means for receiving input from the user and means for providing output to the user. Classical forms of input include keyboard and mouse devices, but also include newer touch screen devices. However, these traditional techniques, although well-suited for particular applications, leave much to be desired in low-cost, low-power, and/or small-size form factors. That is, keyboards and mice are fairly large devices that occupy a large amount of space. In return, they offer the ability to handle fairly complex inputs. Touch screen devices consume a large amount of power, but in return can display large amounts of information or display intricate screens. Simpler devices, such as a simple switches used for light switches or power buttons, offer low cost and small size, but can generally only receive very simple input from a user, such as an on/off command. Further, these switches are passive devices and require an external power supply. US2016070392A1 discloses a method of forming a triboelectric-based sensor comprising a thin film, wherein the thin film comprises a triboelectric thin film comprising a fluorinated ethylene propylene copolymer.

Only some drawbacks to conventional electronic devices and input and output to those devices are described above. However, these drawbacks illustrate a need for further improvements in user input and user feedback to improve capability of electronic devices, such as light switches or consumer smartphones, to interact with users.

### SUMMARY

To better interact with humans, the next generation of electronic devices can use triboelectric sensors to interact with a human's sense of the touch. A triboelectric sensor may determine an amount of force applied to the sensor by a user, such as with their hand or fingers, and translate the applied force to an electrical signal. That electrical signal may be processed and transmitted to another device wirelessly, such that a user may provide input to a remote device. In some embodiments, the triboelectric sensor may also be configured to provide power to components coupled to the triboelectric sensor. Thus, an external power supply for an electronic device that includes the triboelectric sensor may be optionally included or not included. Allowing the electronic device to operate without an external power supply improves the flexibility of the electronic device and increases the number of possible applications for the electronic device.

One example of an electronic device with a triboelectric sensor may be a light switch for a room. A conventional light switch must be wired to the lighting fixture between the lighting fixture and an external power supply. In a large room where a light is on opposite side of the room from the wall switch, a large amount of wire is used to connect the switch to the lighting fixture. The wire often has to pass through wall space or ceiling space that is difficult to access and/or may be damaged during the installation and require time and materials to repair. An electronic device with a triboelectric sensor may be used as a wall switch for a lighting fixture without wiring the switch to the fixture. Instead, the triboelectric-based wall switch may simply be attached to the wall at the desired location. Without a need for an external power supply for the triboelectric-based wall switch, the possible installation location for the wall switch is flexible, whereas a conventional wall switch must be installed somewhere accessible for new wiring. When a user applies force to the triboelectric-based wall switch, a lighting fixture may be turned on or off, the lighting fixture may be set to a desired brightness, and/or the lighting fixture may be set to a desired color.

Although a wall switch is described as one application for embodiments of the invention described herein, other applications are possible. For example, an electronic device with a triboelectric sensor may be incorporated into consumer electronic devices, such as mobile devices, as power switches, as volume controls, or as another input device. Further, although a lighting fixture is described as a receiver, by means of radio frequency (RF) communication, the force sensitive device may communicate a touch event to a suitable RF reader that is connected directly to light bulbs or any other processing unit such as an automation system, light management system, personal computer, or a mobile device that is able to interrogate an RF enabled device. The applications are not limited to light switches, but can be used as a substitute or supplement to any mechanical switching system. These switches may not require wiring to the central unit and the installation is simpler. For example, the mechanical switches in vehicles (e.g., engine start, doors, windows, seats, etc.) can be controlled wirelessly according to embodiments of invention.

According to one embodiment, an apparatus may include a triboelectric-based sensor, a thin film resistor coupled to the triboelectric-based sensor, and a radio-frequency (RF) communications device coupled to the triboelectric-based sensors through the thin film resistor. The apparatus may be configured to receive power from the triboelectric-based sensor, and/or to transmit a wireless signal to a receiving device in response to the receiving of power from the triboelectric-based sensor, wherein the wireless signal indicates an input received at the triboelectric-based signal. In some embodiments, the RF communications device may be configured to receive power and/or data from the triboelectric-based sensor and to transmit a wireless signal based on the received power and/or data. In some embodiments, the reception of power from the triboelectric-sensor may itself represent data, in that the power is generated in response to a user input received at the triboelectric-sensor.

Such an apparatus may be created, such as through an exemplary method that includes forming a triboelectric-based sensor on a substrate; forming a thin film resistor on the substrate; forming a radio-frequency (RF) communications device on the substrate; and/or coupling the radio-frequency (RF) communications device to read-out circuitry and the triboelectric-based sensor through the thin film resistor. The triboelectric-based sensor may be formed with at least one triboelectric thin film layer on a conductive layer. The triboelectric thin film layer may include at least one of a perfluorinated copolymer, PVDF, a copolymer of PVDF, PDMS, PMMA, Teflon, Polymer foam, poly(methyl methacrylate)-co-poly(1H- 1H-perfluorooctyl methacrylate), a fluorinated polymer, and an electronegative polymer. The triboelectric thin film may be modified to increase a friction coefficient, such as by forming a plurality of pillars, either similarly- or differently-sized, on the thin film.

The triboelectric-based sensor and other parts, or all of, the triboelectric-based sensor may be flexible. For example, the sensor or apparatus may be formed on at least one of PET, PEN, PC, PMMA, Polyimide, and a thermoplastic material. In some embodiments, the substrate may also be transparent.

The triboelectric thin film for the triboelectric-based sensor may be manufactured by now or future-developed manufacturing processes. In some embodiment, the triboelectric thin film may be a perfluorinated copolymer, or other statistical copolymer, synthesized by free radical polymerization in benzene. In an embodiment of the invention, the perfluorinated copolymer includes poly(methyl methacrylate)-co-poly(1H- 1H-perfluorooctyl methacrylate), which may be synthesized via free radical polymerization under inert atmosphere condition by the following reaction:

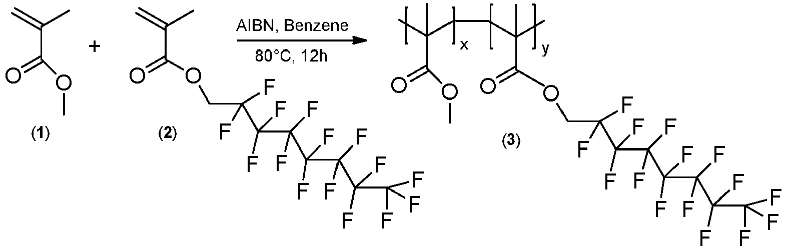

In some embodiments, the perfluorinated copolymer has a molecular weight of approximately 10,000-50,000 and a dispersion ratio of approximately 1.5-2.5. In some embodiments, the perfluorinated copolymer has a controlling perfluoro segment in proportion by weight of more than approximately fifty percent.

The triboelectric-based sensor or apparatus may execute steps to facilitate the processing and transmission of user input received at the triboelectric-based sensor. A processor, or other logic circuitry, may be configured through hardware, software, and/or firmware to execute steps including receiving, at a triboelectric-based sensor of a touch device, an applied force; converting, at the triboelectric-based sensor of the touch device, the applied force to an electric signal; applying, by the triboelectric-based sensor of the touch device, the electric signal to a radio-frequency (RF) communications device of the touch device through a thin film resistor of the touch device; converting, by the radio-frequency (RF) communications device of the touch device, the electric signal to a wireless signal; and/or transmitting, by the radio-frequency (RF) communications device of the touch device, the wireless signal to a receiving device.

The foregoing has outlined rather broadly certain features and technical advantages of embodiments of the present invention in order that the detailed description that follows may be better understood. Additional features and advantages will be described hereinafter that form the subject of the claims of the invention. It should be appreciated by those having ordinary skill in the art that the conception and specific embodiment disclosed may be readily utilized as a basis for modifying or designing other structures for carrying out the same or similar purposes. It should also be realized by those having ordinary skill in the art that such equivalent constructions do not depart from the spirit and scope of the invention as set forth in the appended claims. Additional features will be better understood from the following description when considered in connection with the accompanying figures. It is to be expressly understood, however, that each of the figures is provided for the purpose of illustration and description only and is not intended to limit the present invention.

### BRIEF DESCRIPTION OF THE DRAWINGS

For a more complete understanding of the disclosed system and methods, reference is now made to the following descriptions taken in conjunction with the accompanying drawings.
**FIG. 1** is a block diagram illustrating an apparatus with a triboelectric-based sensor according to one embodiment of the disclosure.
**FIG. 2** is a block diagram illustrating a method of operation of a triboelectric-based sensor according to one embodiment of the disclosure.
**FIG. 3** is a top-down view of a triboelectric-based touch sensor according to one embodiment of the disclosure.
**FIG. 4A** is a cross-section view of a triboelectric-based sensor according to one embodiment of the disclosure.
**FIG. 4B** is a cross-section view of a triboelectric-based sensor with two triboelectric layers according to one embodiment of the disclosure.
**FIG. 4C** is a cross-section view of a triboelectric-based sensor with an array of pillars to improve friction according to one embodiment of the disclosure.
**FIG. 5** is a block diagram illustrating an integrated circuit for processing signals from a triboelectric-based touch sensor according to one embodiment of the disclosure.
**FIG. 6** is a flow chart illustrating an exemplary method for using a triboelectric-based sensor for generating wireless control signals according to one embodiment of the disclosure.
**FIG. 7** is a block diagram illustrating an apparatus with an array of triboelectric-based touch sensors according to one embodiment of the disclosure.
**FIG. 8** is a graph illustrating an example triboelectric-based sensor response according to one embodiment of the disclosure.
**FIG.** 9 is a graph illustrating an example triboelectric-based sensor response to dynamic stimulus according to one embodiment of the disclosure.
**FIG. 10** is a graph illustrating an example load dependence for a triboelectric-based sensor for various resistance values according to some embodiments of the disclosure.
**FIG.** 11 is a graph illustrating example power output for a triboelectric-based sensor for various resistance values according to some embodiments of the disclosure.
**FIG. 12** is a graph illustrating an example response of two triboelectric-based sensors with different active layers according to some embodiments of the disclosure.
**FIG. 13** is a graph illustrating an example response to two triboelectric-based sensors with different polymer layers according to some embodiments of the invention.
**FIG. 14** is an illustration of a room with a triboelectric-based light switch according to one embodiment of the disclosure.
**FIG. 15** is an illustration of a room with a triboelectric-based light switch with an array of triboelectric=based force sensors according to one embodiment of the disclosure.

### DETAILED DESCRIPTION

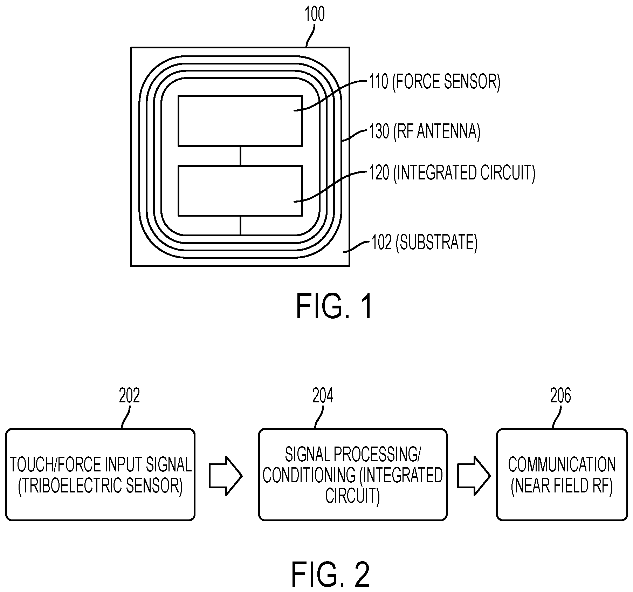

FIG. 1 is a block diagram illustrating an apparatus with a triboelectric-based sensor according to one embodiment of the disclosure. An apparatus 100 may include a force sensor 110, an integrated circuit (IC) 120, and a radio frequency (RF) antenna 130 on a substrate 102. The substrate 102 may be one of PET, PEN, PC, PMMA, Polyimide, or other thermoplastic materials, or flexible or inflexible substrate materials.

The force sensor 110 may include a triboelectric layer configured to generate an output signal proportional to an amount of force applied to the force sensor 110. The triboelectric layer may include one of PVDF and its copolymers (e.g., PVDF-TrFE, PVDF-TrFE CFE, and PVDF-HFP), PDMS, PMMA, Teflon, Polymer foams, or other electronegative polymers. The triboelectric layer of the invention includes poly(methyl methacrylate)-co-poly(1H-1H-perfluorooctyl methacrylate). The force sensor 110 may also include a resistor, which may be made from one or more of tantalum nitride, silicon chromium alloys nickel chromium alloys, transparent conductive materials (e.g., ITO), and/or other resistive materials.

The IC 120 may be coupled to the force sensor 110 to read-out the output signal of the force sensor 110. The IC 120 may process the output signal received from the force sensor 110 to determine an amount of force applied to the force sensor 110. For example, the IC 120 may use a look-up table, an equation, an algorithm, or machine learning to translate an output signal from the force sensor 110 to a relative or absolute force value. In some embodiments, the force value may be used to determine whether a user has touched the force sensor 110. In some touch sensor embodiments, the IC 120 may determine whether the force applied to the force sensor 110 exceeds a threshold amount that would indicate a deliberate touch on the force sensor 110. This binary determination may be used, for example, to turn on or off devices. The IC 120 may include electrodes, interconnects, and/or antennas made from one or more of aluminum, copper, silver, indium tin oxide (ITO), aluminum-doped zinc oxide (AZO), PEDOT:PSS, or any other conductive material.

The IC 120 may transmit the determined applied force, or other values derived from the applied force, through the RF antenna 130. For example, a scaled analog value between 0 and 100 may be generated by the IC 120 based on the output signal of the force sensor 110, and that scaled analog value transmitted through the RF antenna 130. In another example, a binary value of true or false may be generated by the IC 120 based on the output signal of the force sensor 110 being higher or lower than a threshold value, and that binary value transmitted through the RF antenna 130. The IC 120 may communicate using the RF antenna 130 using any wireless communications technique. In some embodiments, the IC 120 may include Bluetooth™ functionality and operate the RF antenna 130 according to the Bluetooth™ standard. In some embodiments, the IC 120 may include WiFi functionality and operate the RF antenna 130 in accordance with the IEEE 802.11 standard. In some embodiments, the IC 120 may include frequency modulation (FM) or amplitude modulation (AM) circuitry to transmit signals through the RF antenna 130.

Exemplary operation of a triboelectric-based sensor, such as by the apparatus of FIG. 1, is described in more detail with reference to FIG. 2. FIG. 2 is a block diagram illustrating a method of operation of a triboelectric-based sensor according to one embodiment of the disclosure. Dataflow for operation of a triboelectric-based sensor may begin at block 202 with an integrated circuit receiving a force input signal from the triboelectric-based force sensor. Then, at block 204, the integrated circuit may perform signal processing, which may include signal conditioning, and/or other mathematical determinations or logic decisions based on the received input from the force sensor of block 202. Next, at block 206, the integrated circuit may communicate wirelessly with another device, such as by transmitting a signal based, at least in part, on a signal received from a force sensor at block 202 and processed in block 204.

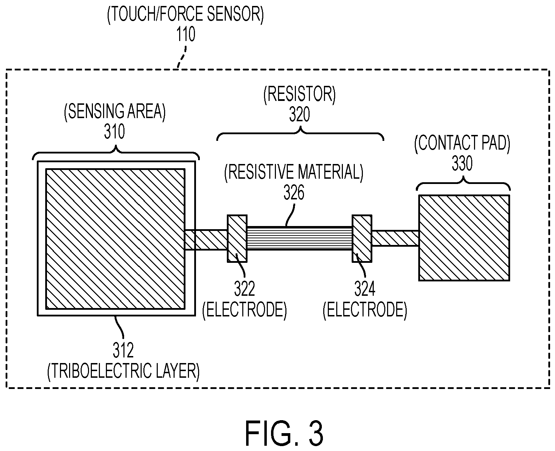

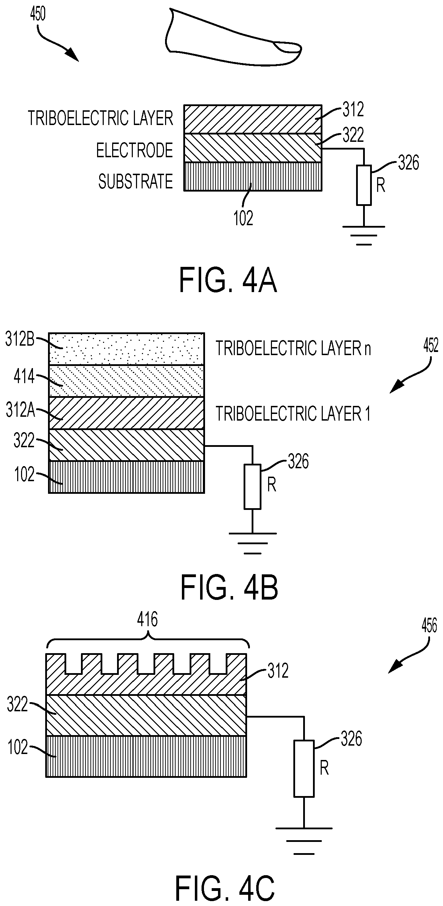

A force sensor 110 may be a triboelectric-based force sensor, such as the example sensor shown in FIG. 3. FIG. 3 is a top-down view of a triboelectric-based touch sensor according to one embodiment of the disclosure. A force sensor 110 may include a sensing area 310 with a triboelectric layer 312. The triboelectric layer 312 may be coupled to an electrode 322 of a resistor 320. The electrode 322 may couple through a resistive material 326 to an electrode 324 of the resistor 320. The resistor 320 may be coupled to a contact pad 330, which may be coupled to other circuitry, such as the integrated circuit 120. A force applied to the sensing area 310 may generate a signal at the contact pad 330 that is proportional to the force applied to the sensing area 310, which may be processed and transmitted by, for example, the integrated circuit 120. In some embodiments, the force sensor 110 may be a thin film device, such as those shown in FIG. 4A, FIG. 4B, and FIG. 4C.

One example of a thin film triboelectric force sensor is shown in FIG. 4A. FIG. 4A is a cross-section view of a triboelectric-based sensor according to one embodiment of the disclosure. A thin film force sensor 450 may include a substrate 102 with a conductive layer 322 deposited thereon to serve as an electrode for resistor 326. A triboelectric layer 312 may be deposited on the conductive layer 322 and configured to translate applied force at the force sensor into a signal through the resistor 326. In some embodiments, the applied force at the force sensor may be user input provided when a user touches the force sensor.

The thin film sensor of FIG. 4A operates using the triboelectric layer to generate charges that are converted into an electrical signal by the resistor 326, and those electrical signals conveyed to an integrated circuit through a contact pad. Charges are generated in the triboelectric layer upon contact with a material having an opposite electro affinity. For example, charges are generated when a human finger touches the triboelectric layer as a result of the principle of contact electrification (e.g., tribo electrification). The power output of the sensor may depend on the load (e.g., resistance) of the system. In some embodiments of the thin film sensor, the resistors are made in a thin film configuration. The signal generated by the triboelectric-based force sensor may be conveyed to a thin film integrated circuit for conditioning and pre-processing before being communicated via near field radio frequency communication to a receiving device, such as a central processing unit (CPU) of a mobile device or any other appropriate reader.

A thin film sensor may include multiple layers of triboelectric material according to one embodiment of the disclosure. FIG. 4B is a cross-section view of a triboelectric-based sensor with two triboelectric layers according to one embodiment of the disclosure. A thin film force sensor 452 may include triboelectric layers 312A and 312B, which may be separated by a buffer layer 414. Multiple triboelectric layers, such as shown in sensor 452, may enhance the triboelectric effect, and thus produce signals with higher magnitudes for processing by an integrated circuit coupled to the sensor 452.

A thin film sensor may include a surface modified to improve contact surface area and/or the friction coefficient between the layers in contact. In one embodiment, the modified surface may include a surface with an array of formed pillars, although other surface modifications may be used in other embodiments. FIG. 4C is a cross-section view of a triboelectric-based sensor with an array of pillars to improve friction according to one embodiment of the disclosure. A thin film force sensor 456 may include triboelectric layer 312 with a surface modified to include an array of pillars 416. The pillars 416 may extend across a portion or the entirety of the sensor 456. The pillars may be approximately uniformly shaped and sized, or the pillars may have different shapes and sizes.

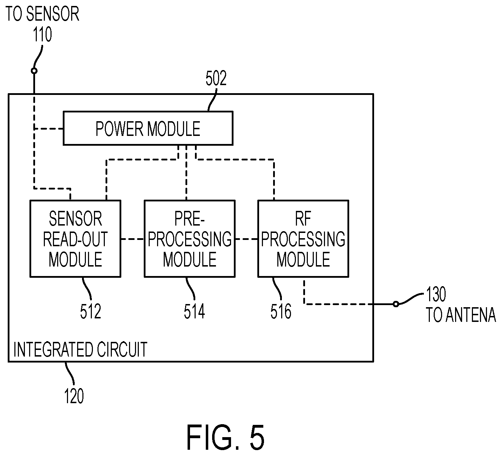

Referring back to FIG. 1, any of the sensor configurations described above, or other sensor configurations incorporating a triboelectric layer, may be coupled to an integrated circuit 120 for reading out, processing, and transmitting an output signal generated by the sensor. One example of such an integrated circuit 120 is shown in FIG. 5. FIG. 5 is a block diagram illustrating an integrated circuit for processing signals from a triboelectric-based touch sensor according to one embodiment of the disclosure. The IC 120 may include an input node for receiving signals from the sensor 111, such as when coupled to a thin film resistor within the sensor 110. The received signal may be received by a sensor read-out module 512. The read-out may be provided to pre-processing module 514, which may perform operations on and/or involving the read-out from the sensor 110. The processed signal may be provided to an RF processing module 516, which may perform operations to transmit data to another device, such as by generating physical signals for output to the antenna 130 or packaging data into frames for output to the antenna 130.

In some embodiments, the IC 120 may include a power module 502, which may also be coupled to the sensor 110. The power module 502 may receive the sensor signal and distribute power to the modules 512, 514, and 516. The power module 502 may include circuitry such as power converters, DC-to-DC converters, charge pumps, and the like to convert the received sensor signal into a steady-state DC power supply for operating the modules 512, 514, and 516. For example, the sensor signal may be converted into a 1.8 Volt DC power supply for operating the modules 512, 514, and 516.

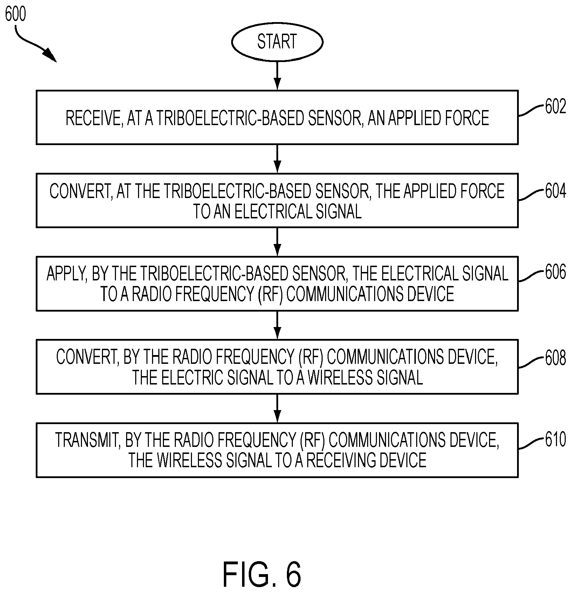

The modules 512, 514, and/or 516 may include circuitry configured to perform the operations described herein. In some embodiments, such as when the IC 120 is a general purpose processor, the modules 512, 514, and/or 516 may include software code that when executed by a general purpose processor cause the processor to perform the operations described herein. In some embodiments, the modules 512, 514, and/or 516 may include circuitry or other hardware configured to perform certain functionality. In some embodiment, the circuitry or other hardware may be configured using firmware. One example of a method for implementation by the modules 512, 514, and/or 516, in cooperation with the sensor 110, is described with reference to FIG. 6.

FIG. 6 is a flow chart illustrating an exemplary method for using a triboelectric-based sensor for generating wireless control signals according to one embodiment of the disclosure. A method 600 may begin at block 602 with receiving, at a triboelectric-based sensor, an applied force. At block 604, the applied force at the triboelectric-based sensor may be converted to an electric signal. For example, a user's finger may apply a force to sensing area 310 of FIG. 3, which generates charges in the triboelectric layer as a result of the principle of contact electrification. The user's applied force may correspond to an input signal. For example, tapping the sensing area 310 may indicate turning on or off a device, such as a lighting device. As another example, tapping the sensing area 310 may indicate initiating or hanging up a telephone call or other communications session. At block 606, the electrical signal from the triboelectric-based sensor may be applied to a radio frequency (RF) communications device. The RF communications device may include an integrated circuit, such as integrated circuit 120 of FIG. 1 or FIG. 5, and RF antenna 130 of FIG. 1. The integrated circuit 120 may include, for example, a sensor read-out module 512, configured to receive the electrical signal from the triboelectric-based sensor at block 606.

The RF communications device may then perform steps to prepare the output of the force sensor for transmission, and then transmit a signal that corresponds to the output of the force sensor. At block 608, the electrical signal may be converted by the RF communications device to a wireless signal. In one embodiment, the conversion of block 608 may be performed by pre-processing module 514 and/or RF processing module 516 of FIG. 5. For example, the electrical signal may be processed and used to generate wireless signals for near-field RF communications. At block 610, the wireless signal may be transmitted by the RF communications device to a receiving device, such as through RF antenna 130. In one embodiment, the transmission of block 610 may be performed by the RF processing module 516 and/or the RF antenna 130. The receiving device may be a lighting device, such as a lamp or communication-enabled LED-based light bulb. The receiving device may alternatively be a computing device, such as a mobile phone, a tablet, a laptop computer, or a desktop computer.

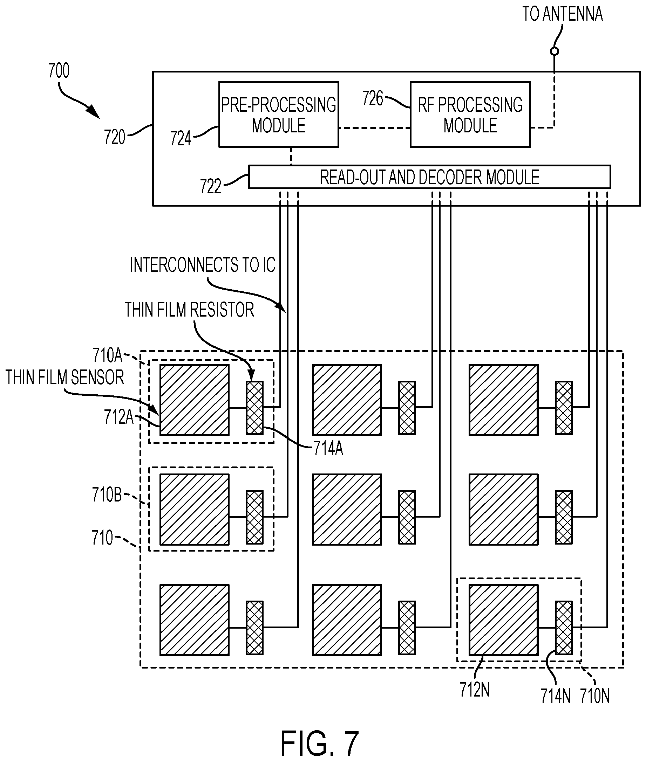

Example embodiments described above include a single triboelectric-based sensor, however, in some embodiments, multiple sensors may be organized into an array FIG. 7 is a block diagram illustrating an apparatus with an array of triboelectric-based touch sensors according to one embodiment of the disclosure. An electronic device 700 may include an array 710 of triboelectric-based sensors. Each of the triboelectric-based sensors 710A-N may include a thin film sensor 712A-N having a triboelectric active layer and a thin film resistor 714A-N. Each of the sensors 710A-N of the array 710 may be coupled to an integrated circuit (IC) 720 for processing the signals generated by the sensors 710A-N. The IC 720 may include a read-out and decoder module 722 configured to receive input signals from each of the sensors 710A-N and decode a resulting output. For example, the module 722 may be able to decode the signals to determine which of the sensors 710A-N were touched. In another example, the module 722 may be able to decode the signals to determine an input value, such as where pressure applied to different areas indicates different input values. The read-out and/or decoded data may be passed to pre-processing module 724 to perform operations similar to the pre-processing module 514 of FIG. 5, and then to RF processing module 726 to perform operations similar to the RF processing module 516 of FIG. 5.

In some embodiments, the thin film sensor array 710 and/or IC 720 may be built on a flexible plastic substrate allowing the device to take different form factors. For example, the device may be fabricated on a flat substrate and, after proper encapsulation, the device may be used as a remote light switch that connects with a reader unit that is connected directly to a light bulb. A device with multiple sensors may be used to control the light intensity by touching different areas of the array of sensors, which are mapped to the different intensities and may be decoded by the module 722. In one mapping, increasing the light intensity may be indicated by a user as consecutive columns are touched.

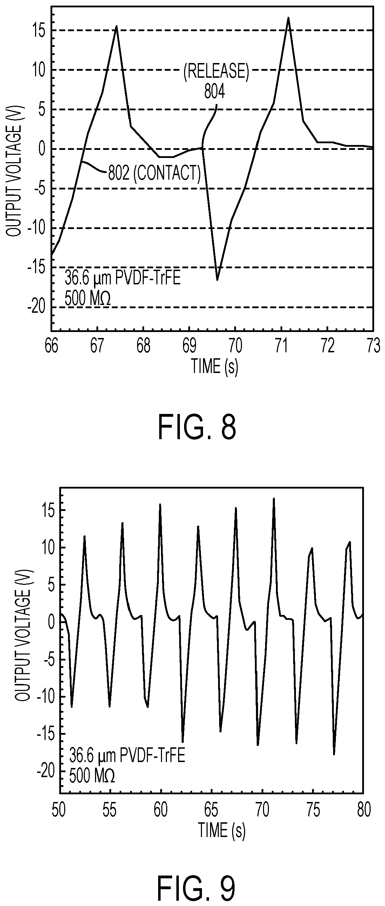

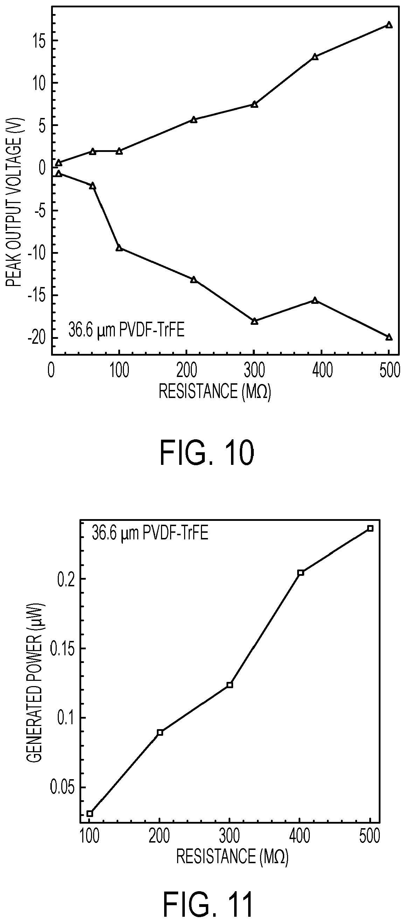

Example outputs for thin film triboelectric sensors according to various embodiments are displayed in FIG. 8, FIG. 9, FIG. 10, FIG. 11, FIG. 12, and FIG. 13. FIG. 8 is a graph illustrating an example triboelectric-based sensor response according to one embodiment of the disclosure having a 36.6 micrometer thick PVDF-TrFE triboelectric active layer and a 500 megaOhm thin film resistor. FIG. 8 shows the response of the triboelectric sensor when stimulated with a touch event. A positive voltage is generated upon contact at time 802, and a negative pulse is recorded after contact release at time 804. FIG. 9 is a graph illustrating an example triboelectric-based sensor response to dynamic stimulus according to one embodiment of the disclosure having a 36.6 micrometer thick PVDF-TrFE triboelectric active layer and a 500 megaOhm thin film resistor. FIG. 9 shows the response of the triboelectric sensor when a dynamic input is applied. The dynamic input is recreated by the stroke-controlled linear motor that presses the sensor with a given frequency. A uniform response can be observed, showing that the sensor is able to generate similar outputs (e.g., peak voltage or peak-to-peak voltage) over the multiple touch events. FIG. 10 is a graph illustrating an example load dependence for a triboelectric-based sensor for various resistance values according to some embodiments of the disclosure having a 36.6 micrometer thick PVDF-TrFE triboelectric active layer. FIG. 10 shows the load dependence response of a sensor in a resistance range from 1 kOhms to 500 MOhms. The power output of the sensor may be controlled by the load (e.g., the load's resistance) that is connected to the sensor. FIG. 11 is a graph illustrating example power output for a triboelectric-based sensor for various resistance values according to some embodiments of the disclosure having a 36.6 micrometer thick PVDF-TrFE triboelectric active layer. FIG. 11 depicts a maximum power generated as a function of coupled resistance.

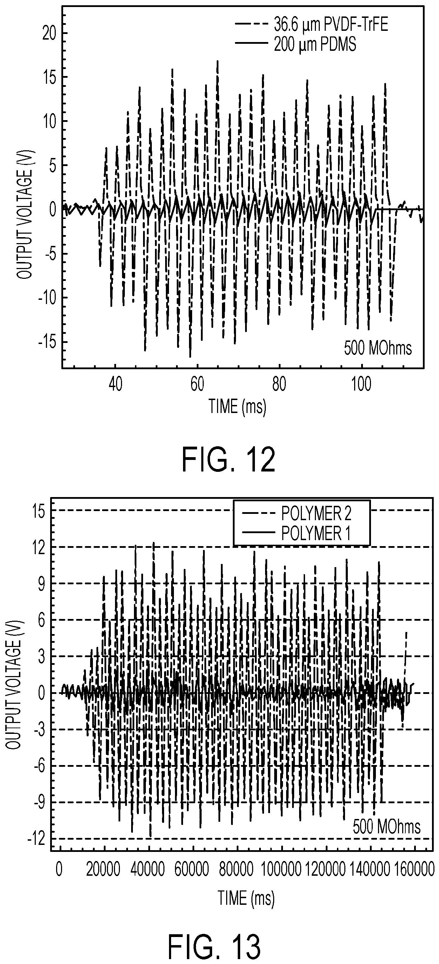

FIG. 12 is a graph illustrating an example response of two triboelectric-based sensors with different active layers according to some embodiments of the disclosure. FIG. 12 shows a comparison of output signals generated by two triboelectric sensors with similar geometry but different active materials and different thicknesses. Polymer 1 is a 200 micrometer PDMS, and Polymer 2 is a 36.6 micrometer PVDF-TrFE layer. Each polymer is used in a sensor that is 1 inch x 1 inch in size with a 500 MOhm resistor. Thinner PVDF-TrFE layers may exhibit higher output voltages when compared with PDMS. The higher electronegativity of the PVDF-TrFE layer may be the reason behind the observed behavior. The higher electronegativity of fluorinated polymers may allow the use of a thinner layer to have a better response. The higher the generated voltage, the higher the touch and force resolution of the sensor. That is, a sensor with a higher voltage response at a given force may be able to detect stimuli with lower intensity, and thus higher force resolution may be achieved.

FIG. 13 is a graph illustrating an example response to two triboelectric-based sensors with different polymer layers according to some embodiments of the invention. FIG. 13 shows the output response of triboelectric sensors having the same device geometry as mentioned before, but using 1.6 um thick poly(methyl methacrylate)-co-poly(1H-1H-perfluorooctyl methacrylate) as the triboelectric layer. FIG. 13 shows the performance of poly(methyl methacrylate)-co-poly(1H-1H-perfluorooctyl methacrylate) with increasing nominal amount of (1H-1H-perfluorooctyl methacrylate) monomer in the polymerization reaction, shown as Polymer 1 [poly(methyl methacrylate)-co-poly(1H-1H-perfluorooctyl methacrylate) 1:1] and Polymer 2 [poly(methyl methacrylate)-co-poly(1H-1H-perfluorooctyl methacrylate) 1:2] on the graph of FIG. 13. FIG. 13 shows certain advantages in using Polymer 2 as the active triboelectric layer, based on the observed output voltage. Polymer 1 (1:1) gives a maximum output voltage of around 2 V, while with polymer 2 (1:2) an output voltage as high as 12 V is observed. The better performance observed in Polymer 2 may be due to the higher Fluorine content in the polymer, which in turn increases the electro-affinity of the material. Triboelectric response is directly proportional to the difference in electro-affinity of the surfaces in contact. The output voltage of Polymer 2 of FIG. 13 is similar to the output voltage observed when using a 36.6 um thick PVDF-TrFE layer, as shown in FIG. 12, but with a much thinner layer of Polymer 2 (e.g., 1.6 micrometers). The use of Polymer 2 may be advantageous as less material is used to achieve a desired output signal.

Thin film triboelectric sensors according to some embodiments of the invention have a triboelectric layer based on a perfluorinated copolymer. The perfluorinated copolymer comprises methacrylate)-co-poly(1H-1H-perfluorooctyl methacrylate). The perfluorinated copolymer may be manufactured by free radical polymerization in benzene. In some embodiments, the perfluorinated copolymer may have a controlling perfluoro segment in proportion by weight of more than approximately fifty percent Particular embodiments of synthesis for a triboelectric thin film are described below, but other copolymers, such as those described above, may be manufactured by different techniques. In one embodiment, synthesis is performed by refluxing Benzene over sodium/potassium alloy in the presence of benzophenone until the characteristic blue color of the benzophenone radical anion was present and then distilled. Azo-bisisobutyronitrile (AIBN) was recrystallized from methanol and dried in vacuum. Methyl methacrylate was freshly distilled under a N₂ atmosphere prior to use. 1H-1H-perfluorooctyl methacrylate was purified by passing through a basic alumina column and dried over Na₂SO₄.

Synthesis of poly(methyl methacrylate)-co-poly(1H-1H-perfluorooctyl methacrylate) may begin with 30 ml of dry benzene in a three-neck round-bottom flask equipped with a nitrogen inlet and reflux condenser in subdued light. After nitrogen gas is passed through the benzene for ∼1.5 hours, 1.0 g (10 mmol) of methyl methacrylate (1) and 1.0 g (2.1 mmol) of 1H-1H-perfluorooctyl methacrylate (2) are added, and the mixture stirred to dissolve the reagents. 20 mg of 2,2'-azobis-isobutyronitrile (AIBN) is then added, and the reaction mixture allowed to react at 80 degrees Celsius while stirring for 12 hours. The resulting viscous solution is precipitated by the addition of 250 ml of methanol. The isolated polymer may be further purified by two subsequent precipitations from chloroform into methanol, and the white polymer dried in vacuum. The resultant copolymer may have a molecular weight of between 5,000 - 50,000, or more particularly 8,700, and a DPI of 1.5-2.5, or more particularly 2.01. According to one embodiment the reaction for synthesizing poly(methyl methacrylate)-co-poly(1H-1H-perfluorooctyl methacrylate) is the reaction shown below:

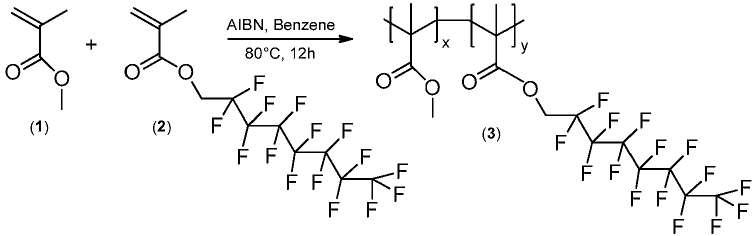

One example of a method for manufacturing a triboelectric sensor is now described, although other techniques and materials may be used in different embodiments of the invention. First, substrate preparation and cleaning is performed on a 100nm PET substrate. After cleaning the substrate in an ultrasonic cleaner using acetone, isopropanol (IPA), and deionized water for 5 minutes in each solvent, the substrate is blow-dried with high purity nitrogen. Then, electrode deposition and patterning may be performed, such as by forming 50 nm Titanium/100 nm Gold electrodes with photolithography and electron beam evaporation. A 4 micrometer-thick AZ EC3027 positive photoresist (PR) is spin-coated on the substrate. The PR layer is then exposed with a broadband UV light source at a dose of 200 mJcm⁻² through a photomask to transfer the desired features. The PR is then developed using AZ 726 MIF developer. Ti/Au electrodes are then deposited using an electron beam evaporator without breaking vacuum. Lift-off using acetone is then performed to remove the unwanted areas and complete the patterning process. Then, triboelectric layer deposition is performed, which may include dissolving P(VDF-TrFE) copolymer (75/ 25 mol%) in dimethyl-formamide (DMF) for 8 hours to have a 20% by-weight solution. Then, the solution is spin-coated on the PET film (with the electrodes on it) at a speed of 1000 rpm, forming a layer of 12.2um PVDF-TrFE. This process may be repeated 3 times to obtain a final thickness of around 36.6 um, or different number of times at different spin speeds to obtain other thicknesses. Each layer may be soft-baked in a hot plate at 50 degrees Celsius for 10 minutes. After finishing the whole process, the film may be annealed in a conventional oven for 4 hours at 135 degrees Celsius under vacuum. Actual devices with a touch resolution of 1 mm and 5 mm were fabricated, although different resolutions are possible. The devices are fabricated using a 100 um thick PET film as the flexible substrate, with 50 nm Titanium/100 nm Gold electrodes, and a 36.6 um thick PVDF-TrFE triboelectric active layer.

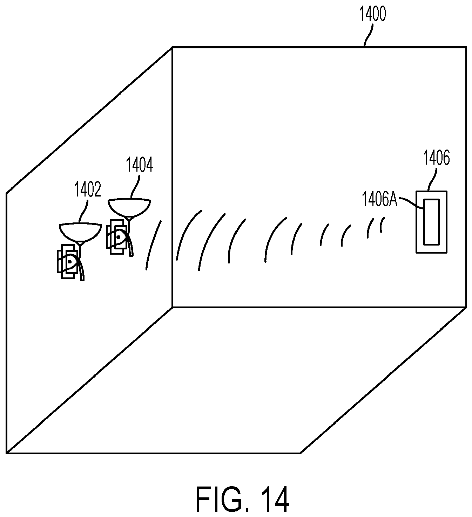

One example application for an electronic device with a triboelectric sensor is wall switches for operating lighting fixtures. FIG. 14 is an illustration of a room with a triboelectric-based light switch according to one embodiment of the disclosure. A room 1400 may include lighting fixtures 1402 and 1404. An electronic device, such as wall switch 1406, may include a triboelectric sensor 1406A. When pressure is applied to the triboelectric sensor 1406A, the sensor 1406A may generate an electrical signal that is conveyed to an RF communications device. An integrated circuit in the RF communications device may receive the signal, process the signal, and generate an RF signal for application to an RF antenna. The RF communications device may thus generate and/or cause transmission of a control signal based on an applied force to the sensor 1406A. The control signal may be transmitted to the lighting fixtures 1402 and 1404 to turn on or turn off the fixtures 1402 and 1404 or to dim the fixtures 1402 and 1404 to a level indicated by the applied force to the sensor 1406A. Although wall lighting fixtures 1402 and 1404 are illustrated in FIG. 14, the wall switch 1406 may control any device in the room, including power outlets, stereo equipment, televisions, air conditioners, heaters, mobile devices, home automation systems, etc.

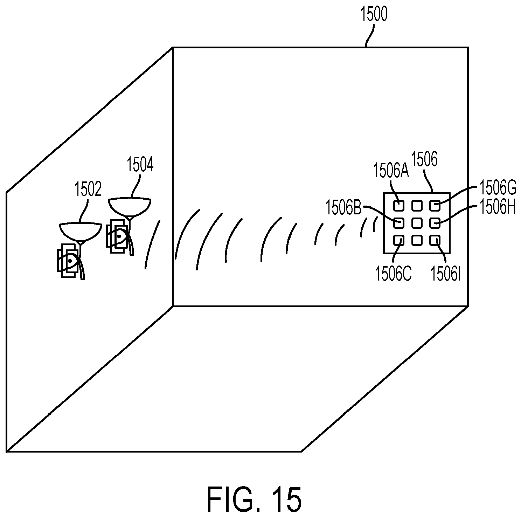

An array of triboelectric sensors may be used in a wall switch for operating lighting fixtures as shown in FIG. 15. FIG. 15 is an illustration of a room with a triboelectric-based light switch with an array of triboelectric-based force sensors according to one embodiment of the disclosure. A room 1500 may include lighting fixtures 1502 and 1504 and a wall switch 1506. The switch 1506 may include triboelectric sensors 1506A-I. The switch 1506 may operate similar to the switch 1406 but transmit different signals or a plurality of signals to a plurality of devices. For example, one sensor 1506A may be used to control the lighting fixture 1502, while a second sensor 1506B may be used to control the lighting fixture 1504. In another example, the sensors 1506A-I may be used to control an intensity of each fixture 1502-1504, such as when one column of sensors 1506A-C varies the intensity of fixture 1502 and another column of sensors 1506D-F varies the intensity of fixture 1504. In a further example, the sensors 1506A-I may be used to control color of the fixtures 1502 and 1504, such as when one column of sensors 1506A-C varies an intensity of emitted red light, a second column of sensors 1506D-F varies an intensity of emitted green light, and a third column of sensors 1506G-I varies an intensity of emitted blue light from the lighting fixtures 1502 and 1504.

If implemented in firmware and/or software, the functions described above, such as with respect to the flow charts of FIG. 2 and FIG. 6, may be stored as one or more instructions or code on a computer-readable medium. Examples include non-transitory computer-readable media encoded with a data structure and computer-readable media encoded with a computer program. Computer-readable media includes physical computer storage media. A storage medium may be any available medium that can be accessed by a computer. By way of example, and not limitation, such computer-readable media can comprise random access memory (RAM), read-only memory (ROM), electrically erasable programmable read-only memory (EEPROM), compact-disc read-only memory (CD-ROM) or other optical disk storage, magnetic disk storage or other magnetic storage devices, or any other medium that can be used to store desired program code in the form of instructions or data structures and that can be accessed by a computer. Disk and disc includes compact discs (CD), laser discs, optical discs, digital versatile discs (DVD), floppy disks, and Blu-ray discs. Generally, disks reproduce data magnetically, and discs reproduce data optically. Combinations of the above should also be included within the scope of computer-readable media.

In addition to storage on computer readable medium, instructions and/or data may be provided as signals on transmission media included in a communication apparatus. For example, a communication apparatus may include a transceiver having signals indicative of instructions and data. The instructions and data are configured to cause one or more processors to implement the functions outlined in the claims.

## Claims

1. A method, comprising:
forming a triboelectric-based sensor comprising one or more thin films,
wherein:
one of the one or more thin films comprises a triboelectric thin film comprising a perfluorinated copolymer; and
the perfluorinated copolymer comprises poly(methyl methacrylate)-co-poly(1 H-1H-perfluorooctyl methacrylate).

2. The method of claim 1, further comprising synthesizing poly(methyl methacrylate)-co-poly(1H-1H-perfluorooctyl methacrylate) by synthesis via free radical polymerization under inert atmosphere condition by a reaction comprising:

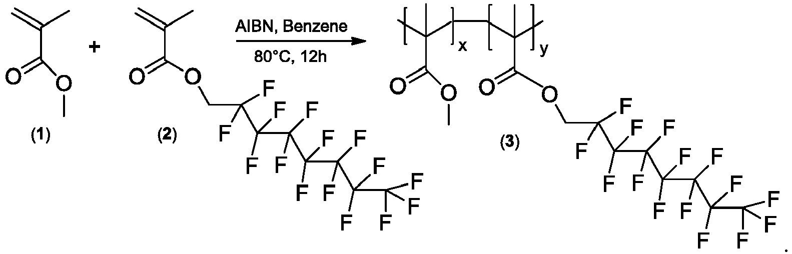

3. The method of claim 1, wherein the perfluorinated copolymer has a controlling perfluoro segment in proportion by weight of more than approximately fifty percent.

4. The method of claim 1, further comprising blending the perfluorinated copolymer with another copolymer.

5. The method of claim 1, wherein the step of forming the triboelectric-based sensor comprises:
forming a conductive thin film on a substrate; and
forming the triboelectric thin film on the conductive thin film.

6. The method of claim 5, wherein the step of forming the triboelectric-based sensor comprises forming a second triboelectric thin film on the triboelectric thin film.

7. The method of claim 5, wherein the step of forming the triboelectric-based sensor comprises modifying a surface of the triboelectric thin film.

8. The method of claim 1, wherein the step of forming the triboelectric-based sensor comprises forming the triboelectric thin film on a conductive thin film.

9. The method of claim 8, 9 , wherein the step of forming the triboelectric-based sensor further comprises forming a thin film resistor coupled to the conductive thin film,

10. The method of claim 9, wherein the step of forming the thin film resistor comprises forming a resistor from at least one of tantalum nitride, silicon chromium alloys nickel chromium alloys, and transparent conductive materials.

11. The method of claim 1, further comprising forming an integrated circuit coupled to the triboelectric-based sensor.

12. The method of claim 11, wherein:
the step of forming the integrated circuit comprises forming a radio frequency (RF) antenna; or
the step of forming the integrated circuit comprises forming electrodes, interconnects, and/or antennas made from one or more of aluminum, copper, silver, indium tin oxide (ITO), aluminum-doped zinc oxide (AZO), PEDOT:PSS, or any other conductive material.

13. The method of claim 1, wherein the step of forming the triboelectric-based sensor comprises forming the triboelectric-based sensors on a substrate comprising at least one of PET, PEN, PC, PMMA, Polyimide, or other thermoplastic materials.

14. The method of claim 1, wherein the step of forming the triboelectric-based sensor comprises forming the triboelectric-based sensors on a flexible substrate.

## Patentansprüche

1. Verfahren, umfassend:
Bilden eines triboelektrisch basierten Sensors, umfassend einen oder mehrere Dünnfilme,
wobei:
einer aus dem einen oder den mehreren Dünnfilmen einen triboelektrischen Dünnfilm, der ein perfluoriertes Copolymer umfasst, umfasst; und
das perfluorierte Copolymer Poly(methylmethacrylat)-co-poly(1H-1H-perfluoroctylmethacrylat) umfasst.

2. Verfahren nach Anspruch 1, ferner umfassend ein Synthetisieren von Poly(methylmethacrylat)-co-poly(1H-1H-perfluoroctylmethacrylat) durch Synthese über freie radikalische Polymerisierung unter inerter Atmosphärenbedingung durch eine Reaktion, umfassend:

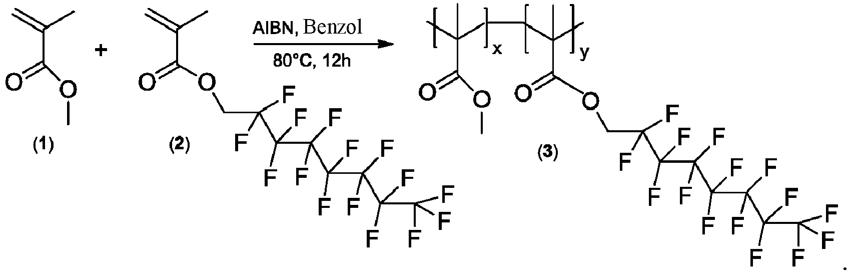

3. Verfahren nach Anspruch 1, wobei das perfluorierte Copolymer ein Perfluorsteuersegment im Gewichtsverhältnis von mehr als ungefähr fünfzig Prozent aufweist.

4. Verfahren nach Anspruch 1, ferner umfassend ein Mischen des perfluorierten Copolymers mit einem anderen Copolymer.

5. Verfahren nach Anspruch 1, wobei der Schritt des Bildens des triboelektrisch basierten Sensors Folgendes umfasst:
Bilden eines leitfähigen Dünnfilms auf einem Substrat; und
Bilden des triboelektrischen Dünnfilms auf dem leitfähigen Dünnfilm.

6. Verfahren nach Anspruch 5, wobei der Schritt des Bildens des triboelektrisch basierten Sensors ein Bilden eines zweiten triboelektrischen Dünnfilms auf dem triboelektrischen Dünnfilm umfasst.

7. Verfahren nach Anspruch 5, wobei der Schritt des Bildens des triboelektrisch basierten Sensors ein Modifizieren einer Oberfläche des triboelektrischen Dünnfilms umfasst.

8. Verfahren nach Anspruch 1, wobei der Schritt des Bildens des triboelektrisch basierten Sensors ein Bilden des triboelektrischen Dünnfilms auf einem leitfähigen Dünnfilm umfasst.

9. Verfahren nach Anspruch 8, wobei der Schritt des Bildens des triboelektrisch basierten Sensors ferner ein Bilden eines Dünnfilmwiderstands, der an den leitfähigen Dünnfilm gekoppelt ist, umfasst.

10. Verfahren nach Anspruch 9, wobei der Schritt des Bildens des Dünnfilmwiderstands ein Bilden eines Widerstands aus mindestens einem aus Tantalnitrid, Silizium-Chrom-Legierungen, Nickel-Chrom-Legierungen und transparenten leitfähigen Materialien umfasst.

11. Verfahren nach Anspruch 1, ferner umfassend ein Bilden eines integrierten Schaltkreises, der an den triboelektrisch basierten Sensor gekoppelt ist.

12. Verfahren nach Anspruch 11, wobei:
der Schritt des Bildens des integrierten Schaltkreises ein Bilden einer Radiofrequenz(RF)-Antenne umfasst; oder
der Schritt des Bildens des integrierten Schaltkreises ein Bilden von Elektroden, Verbindungen und/oder Antennen, die aus einem oder mehreren aus Aluminium, Kupfer, Silber, Indiumzinnoxid (ITO), Aluminium-dotiertem Zinkoxid (AZO), PEDOT:PSS oder einem anderen leitfähigen Material hergestellt werden, umfasst.

13. Verfahren nach Anspruch 1, wobei der Schritt des Bildens des triboelektrisch basierten Sensors ein Bilden der triboelektrisch basierten Sensoren auf einem Substrat, das mindestens eines aus PET, PEN, PC, PMMA, Polyimid oder anderen thermoplastischen Materialen umfasst, umfasst.

14. Verfahren nach Anspruch 1, wobei der Schritt des Bildens des triboelektrisch basierten Sensors ein Bilden der triboelektrisch basierten Sensoren auf einem flexiblen Substrat umfasst.

## Revendications

1. Procédé, comprenant :
la formation d'un capteur à base triboélectrique comprenant un ou plusieurs films minces,
dans lequel :
l'un des un ou plusieurs films minces comprend un film mince triboélectrique comprenant un copolymère perfluoré ; et
le copolymère perfluoré comprend du poly(méthacrylate de méthyle)-co-poly (méthacrylate de 1H-1H-perfluorooctyle).

2. Procédé selon la revendication 1, comprenant en outre la synthèse de poly(méthacrylate de méthyle)-co-poly (méthacrylate de 1H-1H-perfluorooctyle) par synthèse par polymérisation radicalaire sous une atmosphère inerte par une réaction comprenant :

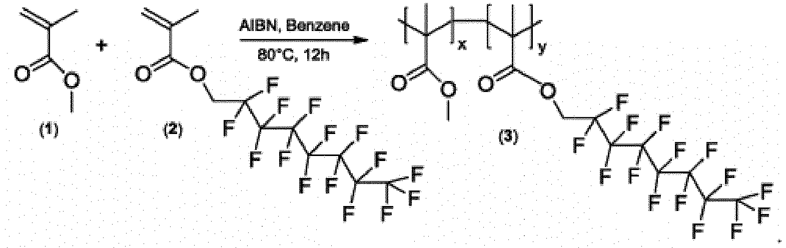

3. Procédé selon la revendication 1, dans lequel le copolymère perfluoré a un segment perfluoro de contrôle en proportion en poids de plus d'environ cinquante pour cent.

4. Procédé selon la revendication 1, comprenant en outre le mélange du copolymère perfluoré avec un autre copolymère.

5. Procédé selon la revendication 1, dans lequel l'étape de formation du capteur à base triboélectrique comprend :
la formation d'un film mince conducteur sur un substrat ; et
la formation du film mince triboélectrique sur le film mince conducteur.

6. Procédé selon la revendication 5, dans lequel l'étape de formation du capteur à base triboélectrique comprend la formation d'un deuxième film mince triboélectrique sur le film mince triboélectrique.

7. Procédé selon la revendication 5, dans lequel l'étape de formation du capteur à base triboélectrique comprend la modification d'une surface du film mince triboélectrique.

8. Procédé selon la revendication 1, dans lequel l'étape de formation du capteur à base triboélectrique comprend la formation du film mince triboélectrique sur un film mince conducteur.

9. Procédé selon la revendication 8, dans lequel l'étape de formation du capteur à base triboélectrique comprend en outre la formation d'une résistance à film mince couplée au film mince conducteur.

10. Procédé selon la revendication 9, dans lequel l'étape de formation de la résistance à film mince comprend la formation d'une résistance à partir d'au moins l'un parmi le nitrure de tantale, les alliages de silicium-chrome, les alliages de nickel-chrome et les matériaux conducteurs transparents.

11. Procédé selon la revendication 1, comprenant en outre la formation d'un circuit intégré couplé au capteur à base triboélectrique.

12. Procédé selon la revendication 11, dans lequel :
l'étape de formation du circuit intégré comprend la formation d'une antenne radiofréquence (RF) ; ou
l'étape de formation du circuit intégré comprend la formation d'électrodes, d'interconnexions et / ou d'antennes d'un ou plusieurs parmi l'aluminium, le cuivre, l'argent, l'oxyde d'indium et d'étain (ITO), l'oxyde de zinc dopé en aluminium (AZO), PEDOT : PSS, ou tout autre matériau conducteur.

13. Procédé selon la revendication 1, dans lequel l'étape de formation du capteur à base triboélectrique comprend la formation des capteurs à base triboélectrique sur un substrat comprenant au moins un parmi le PET, le PEN, le PC, le PMMA, le polyimide ou d'autres matériaux thermoplastiques.

14. Procédé selon la revendication 1, dans lequel l'étape de formation du capteur à base triboélectrique comprend la formation des capteurs à base triboélectrique sur un substrat flexible.
